# EUROPÄISCHE PATENTANMELDUNG

(11) **EP 0 658 940 A1**
(43) Veröffentlichungstag der Anmeldung: **21.06.1995**
(21) Anmeldenummer: 93118841.1
(22) Anmeldetag: 23.11.1993
(51) Int. Cl.: H01L 29/772, H01L 29/72, H01L 29/10

(54) **Durch Feldeffekt steuerbares Halbleiterbauelement**

(71) Anmelder: SIEMENS AKTIENGESELLSCHAFT, D-80333 München (DE)
(72) Erfinder: Laska, Thomas, Dipl.-Phys., D-80796 München (DE)

(57) **Zusammenfassung**

MOSFET und IGBT enthalten parasitäre Strukturen (Bipolartransistor bzw. Thyristor), die z.B. beim Kurzschluß der Last eingeschaltet werden können. Das Bauelement kann dadurch zerstört werden. Das Einschalten der parasitären Strukturen wird dadurch weitgehend unterdrückt, daß die stark dotierte, einen lokalen Kurzschluß zwischen Emitterzone (7) und Basiszone (6) bewirkende Kontaktzone (6) einen lateralen Abstand zur Gateelektrode hat, der zwischen 0 und 1 µm beträgt. Dadurch wird der laterale Spannungsabfall unter dem Emitter (7) (Source) sehr gering gehalten und die am pn-Übergang zwischen Emitter und Kontaktzone abfallende Spannung bleibt kleiner als etwa 0,5 V.

## Beschreibung

Die Erfindung bezieht sich auf ein durch Feldeffekt steuerbares Halbleiterbauelement mit einem Halbleiterkörper mit den Merkmalen:
a) Einer Innenzone vom ersten Leitungstyp,
b) in der Innenzone ist eine Basiszone vom zweiten Leitungstyp eingebettet,
c) in der Basiszone ist eine Emitterzone vom ersten Leitungstyp und höherer Dotierung als die Innenzone eingebettet,
d) einer an die Basiszone angrenzenden Kontaktzone vom zweiten Leitungstyp mit höherer Dotierung als die Basiszone,
e) einer Elektrode, die elektrisch mit der Kontaktzone und der Emitterzone verbunden ist,
f) einer Gateelektrode, die elektrisch isoliert über einem an die Oberfläche tretenden Teil der Basiszone angeordnet ist.

Ein solches Halbleiterbauelement ist z.B. im US-Patent 4,809,947 beschrieben worden. Dort ist ein IGBT erläutert, der zur Erhöhung der Latch-Up-Festigkeit eine stark dotierte Kontaktzone vom Leitfähigkeitstyp der Basiszone enthält. Diese vermindert den Bahnwiderstand derjenigen Ladungsträger, die aus dem Halbleiterkörper kommend lateral unter der Sourcezone entlang bis zur Emitterelektrode fließen.

Um eine möglichst hohe Latch-Up-Festigkeit zu erzielen, sollte die genannte stark dotierte Kontaktzone eine möglichst große laterale Ausdehnung haben. Es muß jedoch vermieden werden, daß sie sich bis unter die Gateelektrode erstreckt, weil dadurch die Einsatzspannung erhöht würde. Dies ist bei dem bekannten IGBT offensichtlich nicht sichergestellt, da hier die Gateelektrode als Implantationsmaske für die Kontaktzone verwendet wird. Durch unvermeidliche Streuungen an der Kante und nachfolgende Wärmebehandlungen läßt es sich nicht vermeiden, daß die Kontaktzone lateral unter die Gateelektrode vorgetrieben wird.

Der Erfindung liegt die Aufgabe zugrunde, ein durch Feldeffekt steuerbares Halbleiterbauelement der beschriebenen Art so weiterzubilden, daß die Kontaktzone einerseits eine möglichst große laterale Ausdehnung hat, daß andererseits eine laterale Überschneidung zwischen dieser Zone und der Gateelektrode sicher vermieden wird.

Dieses Ziel wird dadurch erreicht, daß der laterale Abstand zwischen der Kontaktzone und der Gateelektrode ≧0 und ≦1 µm beträgt.

Die Erfindung wird anhand eines Ausführungsbeispiels in Verbindung mit den Figuren 1 bis 6 näher erläutert. Es zeigen
- Figur 1: einen Schnitt durch einen IGBT gemäß der Erfindung und
- Figur 2 bis 6: verschiedene, charakteristische Verfahrensschritte zur Herstellung verschiedener Zonen des IGBT.

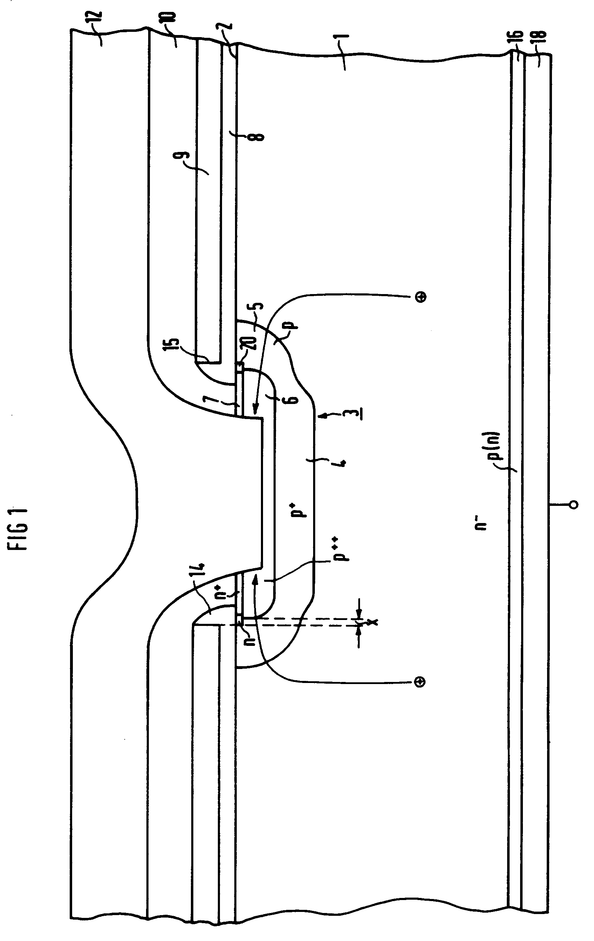

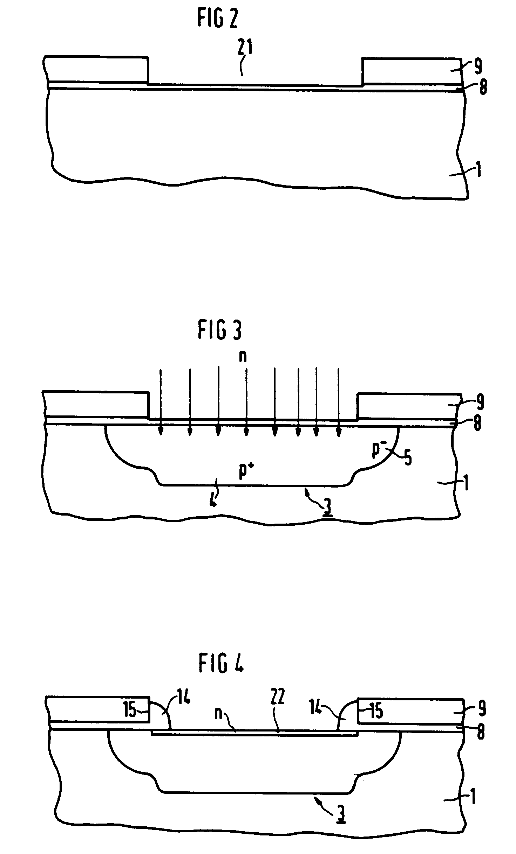

Der Halbleiterkörper nach Figur 1 hat eine schwach n-dotierte Innenzone 1. In der oberen Oberfläche 2 des Halbleiterkörpers ist eine Basiszone 3 eingebettet. Diese Zone besteht aus zwei Teilen, nämlich einem zentralen, stark dotierten, tiefen Teil 4 und einem schwächer p-dotierten, flacheren Randbereich 5. Der Bereich 5 erstreckt sich bis zur Oberfläche 2 des Halbleiterkörpers. In der Basiszone 3 ist eine stark p-dotierte Kontaktzone 6 eingebettet, in dieser wiederum eine stark n-dotierte Emitterzone 7. Die Emitterzone 7 und die Kontaktzone 6 sind innerhalb eines Kontaktlochs mit einer Emitterelektrode 12 verbunden. Auf der Oberfläche 2 des Halbleiterkörpers sitzt eine Isolierschicht 8, auf der eine Gateelektrode 9 angeordnet ist. Sie überdeckt den Randbereich 5 der Basiszone 3 dort, wo dieser an die Oberfläche 2 des Halbleiterkörpers tritt. Die Gateelektrode 9 und die Emitterelektrode 12 sind durch eine Isolierschicht 10 gegenseitig isoliert.

Wesentlich ist, daß zwischen der Kontaktzone 6 und der Kante 15 der Gateelektrode ein Abstand x eingehalten wird, der ≧0 und ≦1 µm ist. Damit wird einerseits vermieden, daß sich die Einsatzspannung des IGBT erhöht. Andererseits finden die aus der p-dotierten Anodenzone 16 stammenden positiven Ladungsträger durch die hohe Dotierung und große laterale Ausdehnung der Kontaktzone 6 einen derart geringen lateralen Widerstand vor, daß die Spannung entlang des pn-Übergangs zwischen Emitterzone 7 und Kontaktzone 6 0,5 V nicht übersteigt. Damit wird die Emission von Elektronen aus der Emitterzone 7 und ein Einschalten des parasitären Thyristors verhindert.

An die Emitterzone 7 kann sich in lateraler Richtung zur Gateelektrode 9 eine weitere Zone 20 anschließen, die den gleichen Leitungstyp wie die Emitterzone 7 hat, jedoch schwächer dotiert ist als diese. Der Zweck dieser Zone besteht darin, den Emitterwirkungsgrad im Randbereich für den Fall herabzusetzen, daß der Abstand x größer als Null ist. Damit wird eine Emission von Elektronen aus der Emitterzone 7 in die Basiszone 3 erschwert. Ohne die weitere Zone würde nämlich ein Teil der hochdotierten Emitterzone 7 direkt dem schwach dotierten Randbereich gegenüberliegen, was einen hohen Emitterwirkungsgrad mit sich brächte.

Die Einstellung des geringen Abstandes x wird durch eine Spacer-Technik ermöglicht, wie sie z.B. von der Herstellung von Speichern oder ähnlich kleinen Strukturen bekannt ist. Der Spacer ist in Figur 1 mit 14 bezeichnet und wird durch eine seitliche Oxidschulter an der Gateelektrode 9 gebildet.

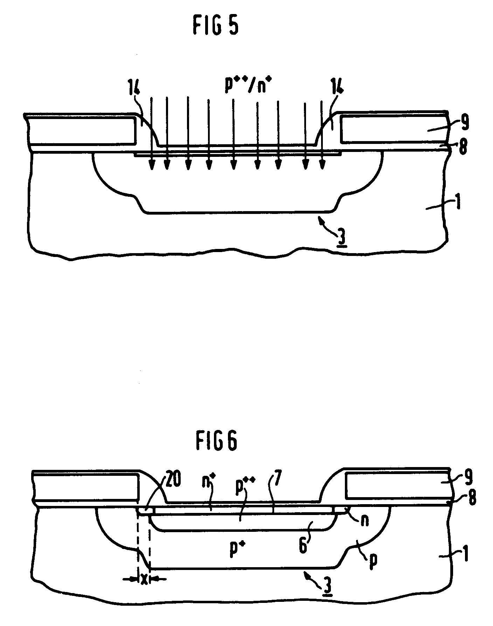

Da die Spacer-Technik jedoch in Verbindung mit Leistungs-Halbleiterbauelementen ungewöhnlich ist, werden die wesentlichen Verfahrensschritte anhand der Figuren 2 bis 6 erläutert. In Figur 2 ist lediglich die Innenzone 1 des Halbleiterkörpers gezeigt. Diese ist mit der Isolierschicht 8 und mit einer strukturierten Polysiliziumschicht bedeckt, die im fertigen Bauelement die Gateelektroden 9 bildet. Die Öffnung in der strukturierten Polysiliziumschicht ist mit 21 bezeichnet. In einem nächsten, nicht dargestellten Schritt wird die Basiszone 3 durch Ionenimplantation und Eindiffusion hergestellt. Gemäß Figur 3 wird dann eine erste n-Implantation durchgeführt, bei der die Gateelektroden 9 als Implantationsmaske wirken. Die Energie und die Dosis ist so eingestellt, daß eine relativ flache, schwach n-dotierte Schicht 22 (Figur 4) entsteht, die durch die Kante 15 der Gateelektroden begrenzt ist. Als nächstes wird der Spacer 14 z.B. dadurch hergestellt, daß die ganze Oberfläche mit einem Oxid bedeckt wird. Dieses Oxid wird dann anisotrop geätzt derart, daß nur die Spacer 14 stehenbleiben.

Als nächstes wird die Kontaktzone durch eine p++-Implantation hergestellt, bei der die Spacer als Maske benutzt werden. Die Emitterzone wird durch eine n⁺-Implantation erzeugt, die sich ebenfalls der Spacer als Maske bedient (Figur 5). Die Energie der Implantationen ist so gewählt, daß die Emitterzone 7 (Figur 6) eine geringere Tiefe hat als die Kontaktzone 6. Die Spacer sind so geformt, daß die Kontaktzone 6 einen solchen Abstand von der Gatekante 15 aufweist, daß nach nachfolgenden Temperaturbehandlungen ein lateraler Abstand x von ≧0 und ≦1 µm gewährleistet bleibt. Dieser Raum wird dann von der weiteren Zone 20 ausgefüllt.

Ein praktisches Ausführungsbeispiel hat folgende Parameter: Tiefe der Basiszone 3 3 µm, Tiefe der Emitterzone 0,15-0,2 µm, Tiefe der Kontaktzone 6 0,75 µm, Kanallänge 2 µm, x = 0 bis 0,5 µm, integrale Nettodotierung der Zone 6 5 · 10¹⁵ cm⁻², der Zone 20 1 · 10¹⁵ cm⁻², der Emitterzone 7 6 · 10¹⁵ cm⁻².

Die Erfindung wurde anhand eines IGBT beschrieben, sie ist aber entsprechend bei Leistungs-MOSFET anwendbar. Dabei ist die p-dotierte Kollektorzone 16 (Figur 1) durch eine n-dotierte Drainzone zu ersetzen. Die Zone 16 ist in beiden Fällen durch eine Elektrode 18 kontaktiert.

## Patentansprüche

1. Durch Feldeffekt steuerbares Halbleiterbauelement mit einem Halbleiterkörper mit den Merkmalen:
a) Einer Innenzone vom ersten Leitungstyp,
b) in der Innenzone ist eine Basiszone vom zweiten Leitungstyp eingebettet,
c) in der Basiszone ist eine Emitterzone vom ersten Leitungstyp und höherer Dotierung als die Innenzone eingebettet,
d) einer an die Basiszone angrenzenden Kontaktzone vom zweiten Leitungstyp mit höherer Dotierung als die Basiszone,
e) einer Elektrode, die elektrisch mit der Kontaktzone und der Emitterzone verbunden ist,
f) einer Gateelektrode, die elektrisch isoliert über einem an die Oberfläche tretenden Teil der Basiszone angeordnet ist,
**gekennzeichnet durch** die Merkmale:
g) der laterale Abstand (x) zwischen der Kontaktzone (6) und der Gateelektrode (9) beträgt ≧0 und ≦1 µm.

2. Halbleiterbauelement nach Anspruch 1,
**dadurch gekennzeichnet,** daß sich in lateraler Richtung an die Emitterzone (7) eine weitere Zone (20) vom ersten Leitungstyp anschließt, die niedriger dotiert ist als die Emitterzone, daß die weitere Zone über die Kontaktzone (6) herausragt und sich lateral bis mindestens zur Gateelektrode (9) erstreckt.

3. Halbleiterbauelement nach Anspruch 2,
**dadurch gekennzeichnet,** daß die weitere Zone (20) eine Breite zwischen 0 und 1 µm hat.
